Europäisches Patentamt

European Patent Office

Office européen des brevets

(11) Veröffentlichungsnummer: **0 403 877**

**A1**

## (12) EUROPÄISCHE PATENTANMELDUNG

(21) Anmeldenummer: **90110708.6**

(22) Anmeldetag: **06.06.90**

(51) Int. Cl.5: **H03C 3/09**

(30) Priorität: **22.06.89 DE 3920533**

(43) Veröffentlichungstag der Anmeldung:
**27.12.90 Patentblatt 90/52**

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Abutorab, Bayati, Dr.- Ing.**
**Schlehenweg 26**
**D-7500 Karlsruhe 21(DE)**

(54) **Frequenzmodulator.**

(57) Frequenzmodulator, mit einer PLL-Schaltung die spannungsgesteuerten Oszillator (VCO) und einen Frequenzuntersetzer (FT) enthält. Dessen frequenzmoduliertes Ausgangssignal wird mit einem Referenzsignal in einem Phasendetektor (PD) verglichen, dessen der Phase-und/oder Frequenzdifferenz entsprechendes Signal über einen Tiefpaß (TP) auf den Steuereingang des spannungsabhängigen Oszillators (VCO) rückgeführt ist. Der Tiefpaß hat (TP) eine obere Grenzfrequenz, die kleiner als die untere Grenzfrequenz des Eingangssignals und damit der Modulationsfrequenz ist. Zwischen den Tiefpaß (TP) und den spannungsgesteuerten Oszillator (VCO) ist eine Addierstufe (A) geschaltet, in der das Ausgangssignal des Tiefpasses (TP) und das Eingangssignal addiert werden.

Die Erfindung wird angewandt bei der Frequenzmodulation von Videosignalen.

EP 0 403 877 A1

# Frequenzmodulator

Die Erfindung betrifft einen Frequenzmodulator gemäß dem Oberbegriff des Anspruchs 1.

Ein solcher Frequenzmodulator mit einer PLL-Schaltung (Phase-Locked-Loop) ist in der Zeitschrift "Der Elektroniker" Nr. 6/1975, Seiten EL9 bis 16 und Nr. 12/1975, Seiten EL6 bis 12 beschrieben. Die Frequenzmodulation erfolgt dadurch, daß ein steuerbarer Frequenzteiler vorgesehen ist, dessen Steuereingang das Eingangssignal zugeführt ist.

Der vorliegenden Erfindung liegt die Aufgabe zugrunde, einen Frequenzmodulator der im Oberbegriff des Anspruchs 1 angegebenen Art zu schaffen, mit dem auch breitbandige Signale, insbesondere Videosignale zur Modulation verwendet werden können.

Erfindungsgemäß wird diese Aufgabe mit den im kennzeichnenden Teil des Anspruchs 1 angegebenen Maßnahmen gelöst.

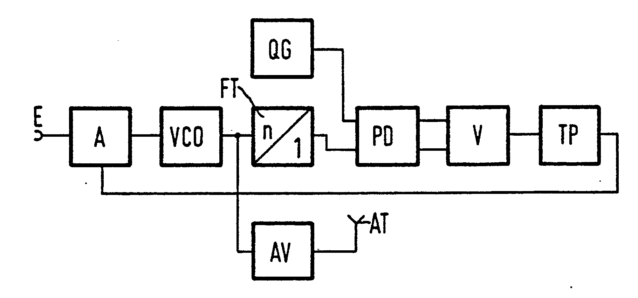

Anhand der Zeichnung, in der das Prinzipschaltbild eines Ausführungsbeispiels dargestellt ist, werden im folgenden die Erfindung sowie Ausgestaltungen und Ergänzungen näher beschrieben und erläutert.

An den Ausgang eines spannungssteuerbaren Oszillators VCO ist ein Frequenzteiler FT angeschlossen, der die Frequenz des Oszillators im Verhältnis n : 1 herabsetzt. Sein Ausgangssignal wird von einem Phasendiskriminator PD mit dem eines Quarzgenerators OG hinsichtlich Phase- und/oder Frequenz verglichen. Das phasen- und/oder frequenzabhängige Differenzsignal wird von einem Niederfrequenzverstärker V verstärkt und über einen Tiefpaß TP dem ersten Eingang einer Addierstufe A zugeleitet, dessen zweiten Eingang über einen Eingang E ein breitbandiges Modulationssignal, z. B. ein Video- oder BAS-Signal, zugeführt ist. Mit dem Ausgangssignal der Addierstufe wird der Oszillator VCO gesteuert. An seinem Ausgang wird das frequenzmodulierte Signal abgenommen, in einem Ausgangsvestärker AV verstärkt und über eine Antenne AT abgestrahlt. Der Tiefpaß TP hat eine obere Grenzfrequenz, die allenfalls gleich, vorteilhaft aber wesentlich niedriger als die untere Grenzfrequenz des Eingangssignals ist.

Ist das Eingangssignal Null, wird das Ausgangssignal des spannungsgesteuerten Oszillators VCO auf eine konstante Trägerfrequenz geregelt, die um den Faktor n größer ist als die des Quarzgenerators QC. Wird das Eingangssignal aufgeschaltet, ändert sich die Frequenz des Trägersignals nicht, da das Frequenzspektrum des Eingangssignals über der Grenzfrequenz des Tiefpasses TP und damit oberhalb der Regelkreisbandbreite liegt. Es entsteht durch die Frequenzmodulation ein Frequenzspektrum, das zur Trägersignalfrequenz symmetrisch ist. Zweckmäßig ist der Ausgangsverstärker AV ein selektiver, auf die Trägersignalfrequenz als Mittenfrequenz abgestimmter Verstärker.

Das Eingangssignal kann über ein gesondertes oder in der Addierstufe A enthaltenes steuerbares Dämpfungsglied bzw. einen steuerbaren Verstärker geführt werden, so daß durch Einstellen seiner Amplitude der Frequenzhub geändert werden kann.

## Ansprüche

1. Frequenzmodulator mit einer PLL-Schaltung, die einen spannungsgesteuerten Oszillator enthält, der ein in Abhängigkeit der Amplitude eines Eingangssignals frequenzmoduliertes Ausgangssignal liefert, und dem ein Frequenzteiler (FT) nachgeschaltet ist, dessen Ausgangssignal mit einem Referenzsignal in einem Phasendetektor (PD) verglichen wird, dessen der Phasen-und/oder der Frequenzdifferenz entsprechendes Ausgangssignal über einen Tiefpaß (TP) auf den Steuereingang des spannungsgesteuerten Oszillators (VCO) rückgeführt ist, **dadurch gekennzeichnet,** daß die obere Grenzfrequenz des Tiefpasses (TP) kleiner als die untere Grenzfrequenz des Eingangssignals ist und daß zwischen den Tiefpaß (TP) und den spannungsgesteuerten Oszillator (VCO) eine Addierstufe (A) geschaltet ist, in der das Ausgangssignal des Tiefpasses (TP) und das Eingangssignal addiert werden.

2. Frequenzmodulator nach Anspruch 1, **dadurch gekennzeichnet,** daß die untere Grenzfrequenz des Eingangssignals im Bereich von 10 bis 100 Hz liegt.

3. Frequenzmodulator nach Anspruch 2, **dadurch gekennzeichnet,** daß das Eingangssignal ein Videosignal, insbesondere ein BAS-Signal ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 707 670 (DAKIN)<br>* Figuren 1,2; Spalte 1, Zeilen 24-31; Spalte 3, Zeilen 11-15,28-32,47-59 * | 1,2 | H 03 C 3/09 |
| Y | | 1,2,3 | |
| | --- | | |
| Y | DE-A-3 125 878 (LICENTIA)<br>* Fig.; Seite 5, Zeile 21 - Seite 6, Zeile 32 * | 1,2,3 | |
| | ------ | | |

**RECHERCHIERTE SACHGEBIETE (Int. Cl.5)**

H 03 C
H 04 N

Der vorliegende Recherchenbericht wurde für alle Patentansprüche erstellt

| Recherchenort | Abschlußdatum der Recherche | Prüfer |
|---|---|---|
| DEN HAAG | 25-09-1990 | GOULDING C.A. |